# EUROPEAN PATENT APPLICATION

(11) **EP 4 757 513 A1**
(43) Date of publication of application: **10.06.2026**
(21) Application number: 24218386.1
(22) Date of filing: 09.12.2024
(51) Int. Cl.: H05K 7/20

(54) **HEAT EXCHANGE DEVICE AND METHOD FOR COOLING DEVICES GENERATING HIGH HEAT FLUX DENSITY, ESPECIALLY PCB**

(71) Applicant: Lisa Dräxlmaier GmbH, 84137 Vilsbiburg (DE); Silesian University of Technology, 44-100 Gliwice (PL)
(72) Inventor: Sznura, Marek, 44172 Poniszowice (PL); Stanislaw, Gorol, 40754 Katowice (PL); Bulinski, Zbigniew, 44190 Knuréw (PL); Krysiriski, Tomasz, 41902 Bytom (PL); Eliasz, Piotr, 41806 Zabrze (PL); Bara, Maciej, 41711 Ruda Slaska (PL)

(57) **Abstract**

The disclosure relates to a heat exchange device (100) for cooling a printed circuit board (110) comprising a plurality of electronic components (111, 112, 113), the heat exchange device (100) comprising: a hollow chamber (150) comprising a base plate (120), a top plate (110) and side walls (130, 131), wherein the top plate (110) is formed by the printed circuit board (110); wherein the base plate (120) comprises a plurality of cooling liquid inlets (141, 142, 143) which are configured to enable a passage of the coolant liquid (151) into the hollow chamber (150); wherein the plurality of cooling liquid inlets (141, 142, 143) are aligned towards the plurality of electronic components on the printed circuit board such that a respective cooling liquid inlet (141, 142, 143) is arranged below a corresponding electronic component (111, 112, 113) to enable the coolant passing through the respective cooling liquid inlet (141, 142, 143) to impinge at a part of the printed circuit board (110) where the corresponding electronic component (111, 112, 113) is attached to.

## Description

### TECHNICAL FIELD

The disclosure relates to the technical field of cooling electronic components. The disclosure relates to a heat exchange device and a method for cooling devices generating high heat flux density, especially a printed circuit board (PCB) with electronic components, by such a heat exchange device. In particular, the disclosure relates to an effective heat exchanger for high heat flux cooling.

### BACKGROUND

The fast development of high power electronic and miniaturisation in the electronic equipment industry results in the increasing demand for effective cooling systems. Such cooling systems should be able on one hand to absorb significant amount of heat and on the other hand do not need complicated circulation systems of coolant that generate high pressure losses and therefore are expensive in construction and maintenance. Finally, due to miniaturisation of electronic systems cooling systems should offer high cooling heat fluxes (heat flow rate per unit area). Active cooling by water (or dedicated coolant) usually are very expensive solutions.

Currently, there are different solutions of cooling systems available: Passive air cooling, i.e., radiator natural convection to the surrounding just provides low heat fluxes which may not be sufficient for increasing demand of effective cooling systems. Active air cooling, i.e., radiator forced convection to the surrounding using fan, also provides low to moderate heat fluxes, which may not be sufficient for increasing demand of effective cooling systems. Active liquid cooling, i.e., heat exchanger, forced convection, water circulation provides moderate to high heat fluxes at high operation cost. Although cooling can be very effective, active liquid cooling is connected with increasing costs. Active or passive phase change cooling, i.e., with a phase change process involved usually evaporation and condensation, provides very high heat fluxes, but the system is complicated and expensive, usually characterized by high investment cost. Moreover, usually CFC (Chlorofluorocarbons) or HCFC (Hydrochlorofluorocarbons) fluids are used for these purposes that have very high GWP (global warming potential) usually hundreds to couple of thousands of CO2 GWP (Note that GWP for CO2 is 1).

### SUMMARY

It is the object of this disclosure to provide a solution for a cooling of electronic components that is compact and provides high cooling heat fluxes at low or moderate costs.

This object is achieved by the features of the independent claims. Further implementation forms are apparent from the dependent claims, the description and the figures.

To overcome the above-described problems the disclosure presents a heat exchanger and a corresponding cooling method. The heat exchanger or heat exchange device has a special construction that takes advantage of extremely high heat transfer coefficient that can be achieved at the fluid impingement point and its neighbourhood. This allows to transfer huge amount of heat between active electronics (e.g., transistor or any other device) and cooling liquid. This results in a very compact heat exchanger with small pressure drop. Moreover, using the presented heat exchanger allows reduction of costs of the cooling system, because it can be even produced from plastics. The presented solution especially suits to cooling of small electronic devices that need very high cooling heat flux in configurations where the heat generation is high and the available heat transfer area is very small.

The solution described in this disclosure provides the following advantages: Obtaining very high cooling heat fluxes; "personalised" cooling: the cooling capacity can be fitted to arrangement (layout) of the heat sources (e.g., transistors or other electronic devices) at the PCB; Lower pressure drop in the circulation system of the cooling liquid at the same cooling capacity compared to other cooling systems; Lower investment cost and maintenance cost with the same cooling capacity compared to the other cooling systems.

The presented solution can be effectively applied for any device where the cooling process needs very high heat fluxes (i.e., heat flow rate per unit area). It can be especially applied to electronic switches, Battery Junction Boxes, boards of power transistors, lasers, fuel cells and many other applications. This solution is cheaper than other solutions and characterized by lower pressure drop of the coolant. The cost of production is lower, and a potentially required water pump with lower power can be applied which is also cheaper.

In this disclosure printed circuit boards (PCBs) are described. A printed circuit board (PCB) is a non-conductive material with conductive lines printed or etched. Electronic components are mounted on the board and the traces connect the components together to form a working circuit or assembly. PCBs or parts of PCBs can be formed flexible or rigid.

According to a first aspect, the disclosure relates to a heat exchange device for cooling a printed circuit board comprising a plurality of electronic components, the heat exchange device comprising: a hollow chamber comprising a base plate, a top plate and side walls, wherein the top plate is formed by the printed circuit board; wherein the base plate comprises a plurality of cooling liquid inlets which are configured to enable a passage of the coolant liquid into the hollow chamber; wherein the plurality of cooling liquid inlets are aligned towards the plurality of electronic components on the printed circuit board such that a respective cooling liquid inlet is arranged below a corresponding electronic component to enable the coolant passing through the respective cooling liquid inlet to impinge at a part of the printed circuit board where the corresponding electronic component is attached to.

Such a heat exchange device provides efficient cooling of electronic components. The device is compact and provides high cooling heat fluxes at low or moderate costs.

The heat exchange device allows to obtain very high cooling heat fluxes. The device allows some kind of "personalised" cooling, where the cooling capacity can be fitted to the arrangement (layout) of the heat sources (which can be for example transistors or other electronic devices) at the PCB. And therefore, the distribution of the heat flux density on the cooled surface can be addressed in the best way (or optimally). The heat exchange device enable lower pressure drop in the circulation system of the cooling liquid at the same cooling capacity compared to other cooling systems. Thus, lower investment cost and maintenance cost can be achieved with the same cooling capacity compared to other cooling systems.

The hollow chamber is a chamber that is hollow and hence the coolant can flow through this chamber. Even during operation of the heat exchange device when the coolant flows through this chamber, the chamber can still be seen as hollow. The hollow chamber can be seen as something that is hollow, i.e., having a space inside it, opposed to being solid all the way through.

In an exemplary implementation of the heat exchange device, one or more of the side walls comprises a cooling liquid outlet which is configured to enable the coolant liquid to exit the hollow chamber.

The coolant liquid outlets allow the coolant to exit the hollow chamber and exchange heat absorbed from the electronic components, i.e., the heat sources, to the environment. Thus, a cooling circuit can be implemented.

In an exemplary implementation of the heat exchange device, the base plate is arranged in parallel to the top plate such that the coolant passing through the respective cooling liquid inlet is orthogonally impinging at the part of the printed circuit board where the exceptionally high heat flux density appears due to generation by the corresponding electronic component attached to it.

In this configuration the impingement of the inflowing liquid takes place directly on the surface of the PCB at the point directly below the heat source. This results in increasing locally the heat transfer coefficient between the cooling liquid and the surface of the PCB at the point closest to the heat source and therefore minimization of the overall heat transfer coefficient between heat source and the cooling liquid.

In an exemplary implementation of the heat exchange device, the side walls are arranged orthogonal to the top plate such that the coolant exiting the hollow chamber flows out in parallel to the printed circuit board.

This decreases possibility of mixing of the coolant, which has absorbed heat from the electronic components, with the fresh coolant entering the hollow chamber.

In an exemplary implementation of the heat exchange device, the cooling liquid outlets of the one or more side walls are spaced apart from the top plate such that the top plate rests on the side walls.

This provides improved stability of the hollow chamber and the heat exchange device.

In an exemplary implementation of the heat exchange device, the printed circuit board is a metal-based printed circuit board comprising a Copper layer onto which the plurality of electronic components are mounted, an Aluminum layer forming a top surface of the hollow chamber and an electrically insulating layer in between.

Such PCB is efficiently absorbing heat from the electronic components and can efficiently transfer the heat to its backside, i.e., the Aluminum layer. The electrically insulating layer can be a moderate thermal conductor, therefore the layer thickness should be minimised in order to transfer heat efficiently to the hollow chamber and the coolant below the electronic components.

In an exemplary implementation of the heat exchange device, the base plate and/or the side walls are made of one or a combination of the following materials: metal, metal alloys, plastic or plastic-like composite.

A construction of metal or metal alloys efficiently transfers heat to the environment and results in a stable and robust heat exchange device while a construction of plastic or plastic-like composite allows to reduce weight of the heat exchange device and can provide a similar stability.

In an exemplary implementation of the heat exchange device, for each electronic component on the printed circuit board an individual cooling liquid inlet is formed in the base plate, wherein the individual cooling liquid inlet is dedicated to the respective electronic component.

By such design, each heat sources (e.g., transistor) can possess its own inlet nozzle that creates the impinging effects at the surface below this heat source. This represents a type of personalized cooling that can be designed in order to fit exactly the need of the specific electronic device and specific distribution of heat flux density generated by it.

In an exemplary implementation of the heat exchange device, a diameter of the individual cooling liquid inlet corresponds to a heat characteristic of the respective electronic component and should be optimized for a given application.

This allows for an adaptation of the design to the specific implementation of the PCB and the electronic components attached to the PCB.

In an exemplary implementation of the heat exchange device, diameters of the cooling liquid inlets can be different.

This allows to achieve an optimal cooling for a PCB with different heat sources having different heat characteristics.

According to a second aspect, the disclosure relates to a method for cooling a printed circuit board comprising a plurality of electronic components by a heat exchange device according to any of the preceding claims, the method comprising: providing a heat exchange device according to any of the preceding claims; and passing a coolant through the plurality of cooling liquid inlets of the base plate into the hollow chamber of the heat exchange device such that the coolant passing through a respective cooling liquid inlet is impinging at a part of the printed circuit board where the corresponding electronic component is attached to.

Such a method provides efficient cooling of electronic components. The method allows to achieve high cooling heat fluxes at low or moderate costs with a compact heat exchange device.

The method allows to obtain very high cooling heat fluxes. As described above with respect to the heat exchange device, the method allows some kind of "personalised" cooling, where the cooling capacity can be fitted to the arrangement (layout) of the heat sources (which can be for example transistors or other electronic devices) at the PCB. The method can achieve lower investment cost and maintenance cost at the same cooling capacity compared to other cooling systems.

In an exemplary implementation of the method, the coolant passing through a respective cooling liquid inlet is favourably orthogonally impinging at the part of the printed circuit board where the corresponding electronic component is attached to. However, some deviation from the orthogonality of the impinging steam is allowed. Small deviations from the orthogonal direction, e.g., up to +/- 30 degrees can be tolerated.

Such configuration results in the impinging of the inflowing liquid directly on the surface of the PCB at the point directly below the heat source which increases locally the heat transfer coefficient between the cooling liquid and the surface of the PCB. Moreover, proximity of the impingement point and the heat source minimize heat transfer resistance between the coolant and the heat source and increases the cooling intensity.

In an exemplary implementation of the method, the method comprises: enabling the coolant to exit the hollow chamber via one or more cooling liquid outlets in the side walls, wherein the coolant exiting the hollow chamber flows out in parallel to the printed circuit board.

This results in an optimum transfer of the coolant, which has absorbed heat from the electronic components, out of the hollow chamber.

### BRIEF DESCRIPTION OF THE DRAWINGS

Further examples will be described with respect to the following figures, in which:
Fig. 1 shows a schematic diagram of a heat exchange device 100 according to the disclosure;
Fig. 2 shows a schematic diagram of a method 200 for cooling a plurality of electronic components by a heat exchange device 100 as shown in Figure 1.

### DETAILED DESCRIPTION OF EMBODIMENTS

In the following detailed description, reference is made to the accompanying drawings, which form a part thereof, and in which is shown by way of illustration specific aspects in which the disclosure may be practiced. It is understood that other aspects may be utilized and structural or logical changes may be made without departing from the scope of the present disclosure. The following detailed description, therefore, is not to be taken in a limiting sense, and the scope of the present disclosure is defined by the appended claims.

It is understood that comments made in connection with a described method may also hold true for a corresponding device or system configured to perform the method and vice versa. Further, it is understood that the features of the various exemplary aspects described herein may be combined with each other, unless specifically noted otherwise.

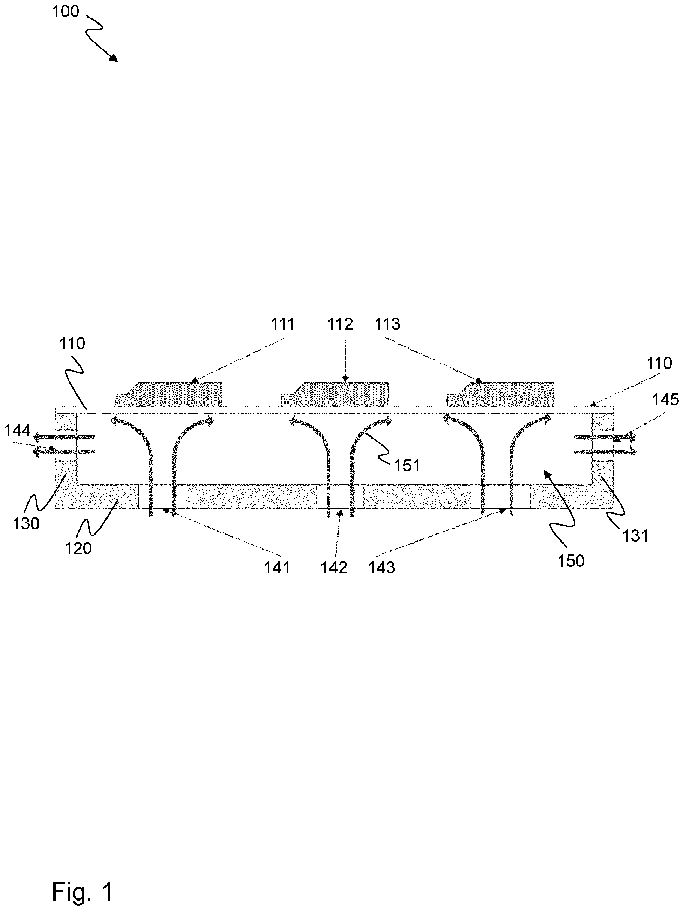

Fig. 1 shows a schematic diagram of a heat exchange device 100 according to the disclosure.

The heat exchange device 100 can be used for cooling a printed circuit board 110 comprising a plurality of electronic components 111, 112, 113, e.g., transistors or other elements producing high amount of heat especially through small area.

The heat exchange device 100 comprises: a hollow chamber 150 comprising a base plate 120, a top plate 110 and side walls 130, 131, wherein the top plate 110 is formed by the printed circuit board 110.

The base plate 120 comprises a plurality of cooling liquid inlets 141, 142, 143 which are configured to enable a passage of the coolant liquid 151 into the hollow chamber 150 as shown in Figure 1.

The plurality of cooling liquid inlets 141, 142, 143 are aligned towards the plurality of electronic components 111, 112, 113 on the printed circuit board 110 such that a respective cooling liquid inlet 141, 142, 143 is arranged below a corresponding electronic component 111, 112, 113 to enable the coolant 151 passing through the respective cooling liquid inlet 141, 142, 143 to impinge at a part of the printed circuit board 110 where the corresponding electronic component 111, 112, 113 is attached to.

The coolant 151 may be driven by a pump system (not shown here) through the cooling liquid inlets 141, 142, 143 into the hollow chamber 150. The pump system may be the same system that is used for cooling the battery in an electric vehicle.

The electronic devices 111, 112, 113 may be mounted at a surface of the PCB opposite to the hollow chamber 150 such that the electronic devices 111, 112, 113 are arranged outside the hollow chamber 150 as shown in Figure 1.

Figure 1 shows one example configuration with three electronic devices 111, 112, 113 that may be transistors, for example. Any other configuration of the PCB 110 with other numbers of electronic devices 111, 112, 113 can be used as well. For example, different types of electronic devices may be used as well such as transistors, resistors, capacitors, inductors, conductors, CPUs or any other element that generates high heat flux.

The heat exchange device 100 may be formed as a box, for example, with the base plate 120 as the base of the box, four side walls 130, 131 as the sides the box and the PCB 110 as the top of the box.

One or more of the side walls 130, 131 may comprise a cooling liquid outlet 144, 145 which is configured to enable the coolant liquid 151 to exit the hollow chamber 150.

The base plate 120 may be arranged in parallel to the top plate 110 such that the coolant 151 passing through the respective cooling liquid inlet 141, 142, 143 is orthogonally impinging at the part of the printed circuit board 110 where the corresponding electronic component 111, 112, 113 is attached to. Small deviations from the orthogonal direction, e.g., up to +/- 30 degrees can be tolerated.

The side walls 130, 131 may be arranged orthogonal to the top plate 110 such that the coolant exiting the hollow chamber 150 flows out in parallel to the printed circuit board 110. A deviation from the orthogonal and parallel directions, e.g., up to +/- 30 degrees can be tolerated.

The cooling liquid outlets 144, 145 of the one or more side walls 130, 131 may be spaced apart from the top plate 110 such that the top plate 110 rests on the side walls 130, 131. This improves stability of the heat exchange device 100.

The printed circuit board 110 may be, for example, a metal-based printed circuit board comprising a Copper layer onto which the plurality of electronic components 111, 112, 113 are mounted, an Aluminum layer forming a top surface of the hollow chamber 150 and an electrically insulating layer in between.

The base plate 120 and/or the side walls 130, 131 may be, for example, made of one or a combination of the following materials: metal, metal alloys, plastic or plastic-like composite.

For each electronic component 111, 112, 113 on the printed circuit board 110 an individual cooling liquid inlet 141, 142, 143 may be formed in the base plate 120, wherein the individual cooling liquid inlet 141, 142, 143 is dedicated to the respective electronic component 111, 112, 113. In other words, each electronic component 111, 112, 113 has its own cooling liquid inlet 141, 142, 143.

A diameter of the individual cooling liquid inlet 141, 142, 143 may correspond to a heat characteristic and size of the respective electronic component 111, 112, 113. That means, for strong heat sources, the diameter of its respective cooling liquid inlet which is arranged below the strong heat source may be greater than for less strong heat sources.

Diameters of at least two of the plurality of cooling liquid inlets 141, 142, 143 may be different, for example if the electronic components 111, 112, 113 (or at least two of them) have different heat characteristics or sizes.

The diameters of the plurality of cooling liquid inlets 141, 142, 143 and also of the cooling liquid outlets 144, 145 may be determined according to an optimization criterion with respect to cooling or power dissipation of the electronic devices 111, 112, 113. For example, a simulation may be run at which diameters of the cooling liquid inlets 141, 142, 143 and the cooling liquid outlets 144, 145 the heat dissipation of the electronic devices is optimal and the heat can be optimally dissipated from the electronic devices to the coolant 151. For such simulation, the depth of the heat exchange device 100, i.e., the distance from the top plate 110 to the base plate 120 is also an optimization parameter for which an optimal value is determined.

The crucial elements in the design shown in Figure 1 are the PCB 110 with the electronic devices 111, 112, 113, e.g., power transistors (i.e., high density heat sources) mounted on it. The PCB 110 may consist of three layers: copper layer to which electronic elements 111, 112, 113 can be soldered, electric isolator layer and aluminum layer.

To the surface opposite to the surface at which the electronic devices 111, 112, 113 are soldered, the heat exchanger 100 (without top plate) can be attached. The heat exchanger 100 can be made of any material (metallic alloys, for example), preferably a kind of plastic or plastic like composite. The heat exchanger may be constructed in such a way that its top wall 110 is the PCB 110 itself.

The crucial element of the presented solution is the placement of inlet (inlet nozzles) 141, 142, 143 and outlet stub pipes 144, 145. The inlet stub pipes 141, 142, 143 favorably may be positioned centrally below the heat source attached to the opposite side of the PCB 110 and the axes of the stub pipes 141, 142, 143 can be perpendicular to the cooled surface. This results in the impinging of the inflowing liquid 151 directly on the surface of the PCB 110 at the point directly below the heat source 111, 112, 113 which increases locally the heat transfer coefficient between the cooling liquid 151 and the surface of the PCB 110.

Each heat source (e.g., transistor) 111, 112, 113 can possess its own inlet nozzle 141, 142,143 that creates the impinging effects at the surface below this heat source. This represents a type of personalized cooling that can be designed in order to fit exactly the need of the specific electronic device 111, 112, 113.

The outlet nozzles 144, 145 may be positioned on the side walls 130, 131 of the heat exchanger 100 in such a way that the direction of movement of outflowing cooling fluid is parallel to the PCB surface.

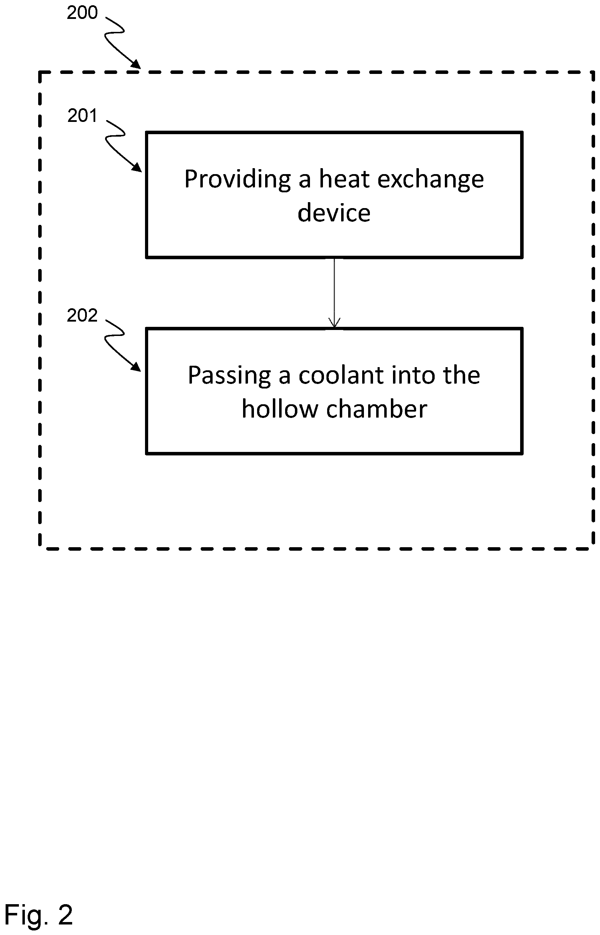

Fig. 2 shows a schematic diagram of a method 200 for cooling a plurality of electronic components by a heat exchange device 100 as shown in Figure 1.

The printed circuit board 110 comprises a plurality of electronic components 111, 112, 113 as shown in Figure 1.

The method 200 comprises: providing 201 a heat exchange device 100 as described above with respect to Figure 1.

The method 200 comprises: passing 202 a coolant 151 through the plurality of cooling liquid inlets 141, 142, 143 of the base plate 120 into the hollow chamber 150 of the heat exchange device 100 such that the coolant 151 passing through a respective cooling liquid inlet 141, 142, 143 is impinging at a part of the printed circuit board 110 where the corresponding electronic component 111, 112, 113 is attached to.

The coolant 151 passing through a respective cooling liquid inlet 141, 142, 143 is orthogonally impinging at the part of the printed circuit board 110 where the corresponding electronic component 111, 112, 113 is attached to.

The method 200 may further comprise: enabling the coolant 151 to exit the hollow chamber 150 via one or more cooling liquid outlets 144, 145 in the side walls 130, 131, wherein the coolant 151 exiting the hollow chamber 150 flows out in parallel to the printed circuit board 110. That means, a flow direction of the coolant 151 exiting through the cooling liquid outlets 144, 145 is parallel to a surface of the printed circuit board 110.

While a particular feature or aspect of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Also, the terms "exemplary", "for example" and "e.g." are merely meant as an example, rather than the best or optimal. The terms "coupled" and "connected", along with derivatives may have been used. It should be understood that these terms may have been used to indicate that two elements cooperate or interact with each other regardless whether they are in direct physical or electrical contact, or they are not in direct contact with each other.

Although specific aspects have been illustrated and described herein, it will be appreciated by those of ordinary skill in the art that a variety of alternate and/or equivalent implementations may be substituted for the specific aspects shown and described without departing from the scope of the present disclosure. This application is intended to cover any adaptations or variations of the specific aspects discussed herein.

Although the elements in the following claims are recited in a particular sequence with corresponding labeling, unless the claim recitations otherwise imply a particular sequence for implementing some or all of those elements, those elements are not necessarily intended to be limited to being implemented in that particular sequence.

Many alternatives, modifications, and variations will be apparent to those skilled in the art in light of the above teachings. Of course, those skilled in the art readily recognize that there are numerous applications of the invention beyond those described herein. While the present invention has been described with reference to one or more particular embodiments, those skilled in the art recognize that many changes may be made thereto without departing from the scope of the present invention. It is therefore to be understood that within the scope of the appended claims and their equivalents, the invention may be practiced otherwise than as specifically described herein.

### LISTING OF REFERENCE SIGNS

- 100: heat exchange device, heat exchanger
- 110: printed circuit board, PCB, metal-based PCB, top plate
- 111, 112, 113: electronic components, e.g., transistors
- 120: base plate
- 130, 131: side walls
- 141, 142, 143: cooling liquid inlets
- 144, 145: cooling liquid outlets
- 150: hollow chamber
- 151: coolant, coolant liquid

- 200: method for cooling electronic components
- 201: first method step
- 202: second method step

## Claims

1. A heat exchange device (100) for cooling a printed circuit board (110) comprising a plurality of electronic components (111, 112, 113), the heat exchange device (100) comprising:
a hollow chamber (150) comprising a base plate (120), a top plate (110) and side walls (130, 131), wherein the top plate (110) is formed by the printed circuit board (110);
wherein the base plate (120) comprises a plurality of cooling liquid inlets (141, 142, 143) which are configured to enable a passage of the coolant liquid (151) into the hollow chamber (150);
wherein the plurality of cooling liquid inlets (141, 142, 143) are aligned towards the plurality of electronic components on the printed circuit board such that a respective cooling liquid inlet (141, 142, 143) is arranged below a corresponding electronic component (111, 112, 113) to enable the coolant passing through the respective cooling liquid inlet (141, 142, 143) to impinge at a part of the printed circuit board (110) where the corresponding electronic component (111, 112, 113) is attached to.

2. The heat exchange device (100) of claim 1,
wherein one or more of the side walls (130, 131) comprises a cooling liquid outlet (144, 145) which is configured to enable the coolant liquid (151) to exit the hollow chamber (150).

3. The heat exchange device (100) of claim 1 or 2,
wherein the base plate (120) is arranged in parallel to the top plate (110) such that the coolant passing through the respective cooling liquid inlet (141, 142, 143) is orthogonally impinging at the part of the printed circuit board (110) where a corresponding exceptionally high heat flux density appears due to generation by the electronic component (111, 112, 113) attached to it.

4. The heat exchange device (100) of any of the preceding claims,
wherein the side walls (130, 131) are arranged orthogonal to the top plate (110) such that the coolant exiting the hollow chamber (150) flows out in parallel to the printed circuit board (110).

5. The heat exchange device (100) of claim 2,
wherein the cooling liquid outlets (144, 145) of the one or more side walls (130, 131) are spaced apart from the top plate (110) such that the top plate (110) rests on the side walls (130, 131).

6. The heat exchange device (100) of any of the preceding claims,
wherein the printed circuit board (110) is a metal-based printed circuit board comprising a Copper layer onto which the plurality of electronic components (111, 112, 113) are mounted, an Aluminum layer forming a top surface of the hollow chamber (150) and an electrically insulating layer in between.

7. The heat exchange device (100) of any of the preceding claims,
wherein the base plate (120) and/or the side walls (130, 131) are made of one or a combination of the following materials: metal, metal alloys, plastic or plastic-like composite.

8. The heat exchange device (100) of any of the preceding claims,
wherein for each electronic component (111, 112, 113) on the printed circuit board (110) an individual cooling liquid inlet (141, 142, 143) is formed in the base plate (120), wherein the individual cooling liquid inlet (141, 142, 143) is dedicated to the respective electronic component (111, 112, 113).

9. The heat exchange device (100) of claim 8,
wherein a diameter of the individual cooling liquid inlet (141, 142, 143) corresponds to a heat characteristic of the respective electronic component (111, 112, 113).

10. The heat exchange device (100) of any of the preceding claims,
wherein diameters of the cooling liquid inlets (141, 142, 143) are different or equal.

11. A method (200) for cooling a printed circuit board (110) comprising a plurality of electronic components (111, 112, 113) by a heat exchange device (100) according to any of the preceding claims, the method comprising:
providing (201) a heat exchange device (100) according to any of the preceding claims; and
passing (202) a coolant (151) through the plurality of cooling liquid inlets (141, 142, 143) of the base plate (120) into the hollow chamber (150) of the heat exchange device (100) such that the coolant (151) passing through a respective cooling liquid inlet (141, 142, 143) is impinging at a part of the printed circuit board (110) where the corresponding electronic component (111, 112, 113) is attached to.

12. The method of claim 11,
wherein the coolant (151) passing through a respective cooling liquid inlet (141, 142, 143) is within a tolerance range orthogonally impinging at the part of the printed circuit board (110) where the corresponding electronic component (111, 112, 113) is attached to.

13. The method of claim 11 or 12,
enabling the coolant (151) to exit the hollow chamber (150) via one or more cooling liquid outlets (144, 145) in the side walls (130, 131), wherein the coolant (151) exiting the hollow chamber (150) flows out in parallel to the printed circuit board (110).
